# EUROPEAN PATENT APPLICATION

(11) **EP 2 626 896 A1**
(43) Date of publication of application: **14.08.2013**
(21) Application number: 11830511.9
(22) Date of filing: 22.09.2011
(51) Int. Cl.: H01L 23/08, H01L 23/02, H01L 23/28, H01L 25/07, H01L 25/18

(54) **SEMICONDUCTOR DEVICE AND METHOD OF PRODUCING SEMICONDUCTOR DEVICE**

(30) Priority: 07.10.2010 JP 2010227823
(71) Applicant: Nissan Motor Co., Ltd, Yokohama-shi, Kanagawa 221-0023 (JP)
(72) Inventor: TAKARAGI, Shinichi, Atsugi-shi, Kanagawa 243-0123 (JP); NAMIKI, Kazushige, Atsugi-shi, Kanagawa 243-0123 (JP); ASAKURA, Daisuke, Atsugi-shi, Kanagawa 243-0123 (JP); NARUSE, Mikio, Atsugi-shi, Kanagawa 243-0123 (JP); MURAI, Hiroaki, Atsugi-shi, Kanagawa 243-0123 (JP); FURUKAWA, Motoyuki, Atsugi-shi, Kanagawa 243-0123 (JP)
(74) Representative: Grünecker, Kinkeldey, Stockmair & Schwanhäusser
(86) International application number: PCT/JP2011/071620
(87) International publication number: WO 2012/046578

(57) **Abstract**

A semiconductor device includes an electric conduction portion having a flat plate shape, a semiconductor element being arranged vertically over the electric conduction portion and being electrically connected thereto, a casing whose lower portion of an inner wall has a coupling portion coupled with a circumferential edge portion of the electric conduction portion and whose upper portion of the inner wall surrounds the whole circumference of the electric conduction portion and a sealing material that vertically downwardly encapsulates the semiconductor element and the electric conduction portion. The electric conduction portion and the casing are integrally molded, and a space having a shape coupled to a circumferential edge portion of the electric conduction portion is provided in the lower portion of the inner wall of the casing as the coupling portion.

## Description

### TECHNICAL FIELD

The present invention relates to a semiconductor device and a method of manufacturing the semiconductor device, and more particularly, to prevention for leakage of a sealing material.

### BACKGROUND ART

JP2009-32733A discloses a lead frame for a semiconductor device, in which a convex portion is provided in one of the frames, a concave portion meshing with the convex portion is provided in the other frame, and the convex and concave portions mesh with each other when the two frames are overlappingly combined. As a result, since a movement distance from a sealing portion at the event of gel leakage increases, it is possible to delay time until the gel leaks.

### SUMMARY OF THE INVENTION

However, in the technique disclosed in JP2009-32733A, the convex portion simply meshes with the concave portion. Therefore, a gap necessary for the meshing inevitably exists between the convex portion and the concave portion. For this reason, a sealing material leaks from the gap existing between the convex and concave portions as time elapses.

The present invention provides an apparatus and method capable of preventing the sealing material from leaking even when time elapses.

A semiconductor device of the present invention comprises an electric conduction portion having a flat plate shape, a semiconductor element being arranged vertically over the electric conduction portion and being electrically connected thereto, a casing whose lower portion of an inner wall has a coupling portion coupled with a circumferential edge portion of the electric conduction portion and whose upper portion of the inner wall surrounds the whole circumference of the electric conduction portion and a sealing material that vertically downwardly encapsulates the semiconductor element and the electric conduction portion. The electric conduction portion and the casing are integrally molded, and a space having a shape coupled to a circumferential edge portion of the electric conduction portion is provided in the lower portion of the inner wall of the casing as the coupling portion.

### BRIEF DESCRIPTION OF THE DRAWINGS

The foregoing and additional features and characteristics of this disclosure will become more apparent from the following detailed description considered with the reference to the accompanying drawings, wherein:

FIG. 1 is a circuit diagram illustrating a three-phase inverter for driving a motor according to the first embodiment of the present invention;
FIG. 2 is a cross-sectional view illustrating a single power module according to the first embodiment;
FIG. 3A is a partially enlarged cross-sectional view illustrating a power module according to the first embodiment;
FIG. 3B is a partially enlarged cross-sectional view of FIG. 3A;
FIG. 4A is a partially enlarged cross-sectional view illustrating a power module according to the second embodiment;
FIG. 4B is a partially enlarged cross-sectional view of FIG. 4A;
FIG. 4C is a diagram illustrating a modification of the configuration of FIG. 4A;
FIG. 5A is a partially enlarged cross-sectional view illustrating a power module according to the third embodiment;
FIG. 5B is a partially enlarged cross-sectional view of FIG. 5A;
FIG. 6A is a partially enlarged cross-sectional view illustrating a power module according to the fourth embodiment; and
FIG. 6B is a partially enlarged cross-sectional view illustrating a portion circled by a dotted line in FIG. 6A.

### DESCRIPTION OF THE EMBODIMENTS

Hereinafter, embodiments of the present invention will be described in detail with reference to the accompanying drawings.

### <First Embodiment>

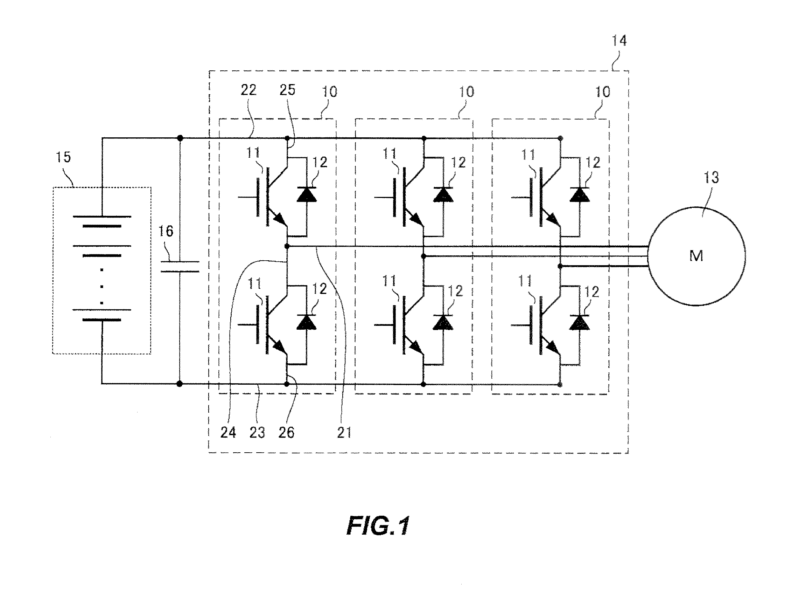

FIG. 1 is a circuit diagram illustrating a three-phase inverter 14 for driving a motor having a non-insulation type power module 10 according to the first embodiment of the present invention. As illustrated in FIG. 1, a single power module 10 includes a plurality of power semiconductors 11 (semiconductor elements) and a plurality of free wheeling diodes 12 (semiconductor elements). Each free wheeling diode 12 is connected to each power semiconductor 11 in reverse parallel.

The power semiconductor 11 includes a semiconductor element such as a thyristor, a gate turn-off thyristor (GTO), and an insulated gate bipolar transistor (IGBT). This single power module 10 corresponds to a single phase of the three-phase inverter 14 for driving an AC motor 13. Electric power of a DC power supply 15 is converted into three-phase AC electric power for driving the AC motor 13 using a smoothing capacitor 16 and three power modules 10. The AC motor 13 is used, for example, in an electric vehicle (EV) or a hybrid electric vehicle (HEV).

Specifically, an external busbar (output side) 21 for connecting the AC motor 13 and the inverter 14, an external busbar (P-side) 22 for connecting the DC power supply 15 and the inverter 14, and an external busbar (N-side) 23 are connected to the inverter 14. The single power module 10 includes an output electrode 24 connected to the external busbar (output side) 21, a P-type electrode 25 connected to the external busbar (P-side) 22, and an N-type electrode 26 connected to the external busbar (N-side) 23.

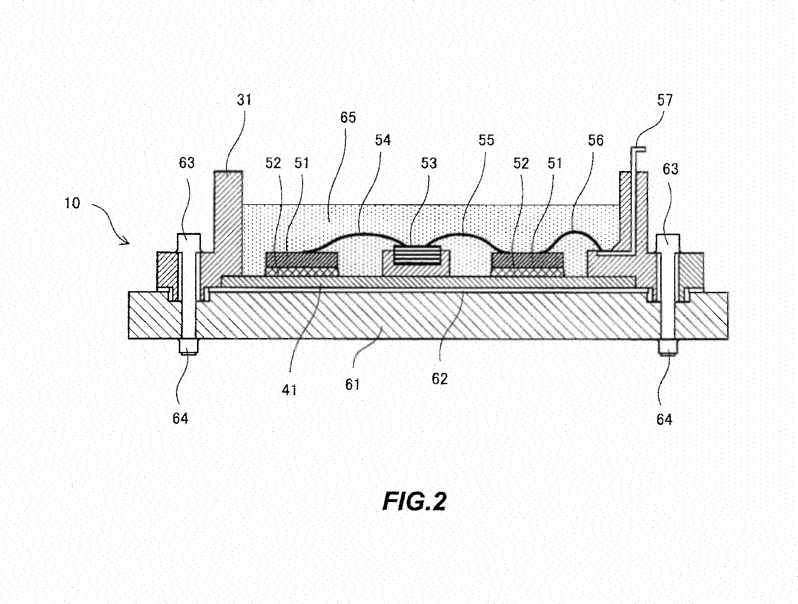

FIG. 2 is a cross-sectional view illustrating a single power module 10. Although three power modules 10 are illustrated in FIG. 1, they have the same configuration. In the circuit diagram of FIG. 1, only two power semiconductors and two free wheeling diodes are illustrated for the single power module 10. However, in a packaging state, for a single power module 10, four power semiconductors and four free wheeling diodes are used, and two power semiconductors and two free wheeling diodes are connected to each other in parallel.

The power module 10 includes, inside the casing 31, a chip mounting electrode 41 (electric conduction portion) integrally molded with the casing 31, a plurality of semiconductor chips 51 arranged (mounted) vertically over the chip mounting electrode 41, and a cooler 61 for cooling the semiconductor chip 51. In addition, the cooler 61 serves as a base portion for fixing the casing 31 and the chip mounting electrode 41 in an electrically insulated state. Out of the two semiconductor chips 51 provided in the left and right sides, if one of the semiconductor chips 51 is a power semiconductor 11, the other semiconductor chip 51 is a free wheeling diode 12.

The two semiconductor chips 51 of the left and right sides are bonded vertically over the chip mounting electrode 41 so as to be electrically conductible using solder 52. The semiconductor chips 51 are connected to a strong electricity electrode terminal 53 fixed to the casing 31 using bonding wires 54 to 56 or an electricity conduction metal electrode 57. The electrode terminal 53 positioned in the center is electrically connected to an external busbar using a screw. In addition, the external busbar is one of the external busbar (P-side), the external busbar (N-side), and the external busbar (output side).

The cooler 61 is fixed vertically under the power module 10. Between the cooler 61 and the chip mounting electrode 41, an insulation sheet 62 for electrically insulating these components is interposed. Grease for obtaining insulation and increasing thermal conductivity is soaked or impregnated into the insulation sheet 62.

The casing 31 and the cooler 61 are fixed using installation members such as a bolt 63 and a nut 64. That is, the chip mounting electrode 41 and the insulation sheet 62 are interposed by the casing 31 and the cooler 61 and are fixed together using a bolt 63 and a nut 64. As a result, each component of the power module 10 is fixed.

In order to prevent a surface of the semiconductor chip 51 (semiconductor element) from being oxidized or corroded by making contact with moisture or oxygen in the air, the interior of the casing 31 is sealed with an sealing material 65. That is, the sealing material 65 vertically downwardly encapsulates the semiconductor chip 51 and the chip mounting electrode 41. Gel-like resin is used as the sealing material 65.

In this manner, in the power module 10 in which the interior of the casing 31 is sealed with the sealing material 65, there is a problem in that the sealing material 65 leaks from a gap between the casing 31 and the chip mounting electrode 41.

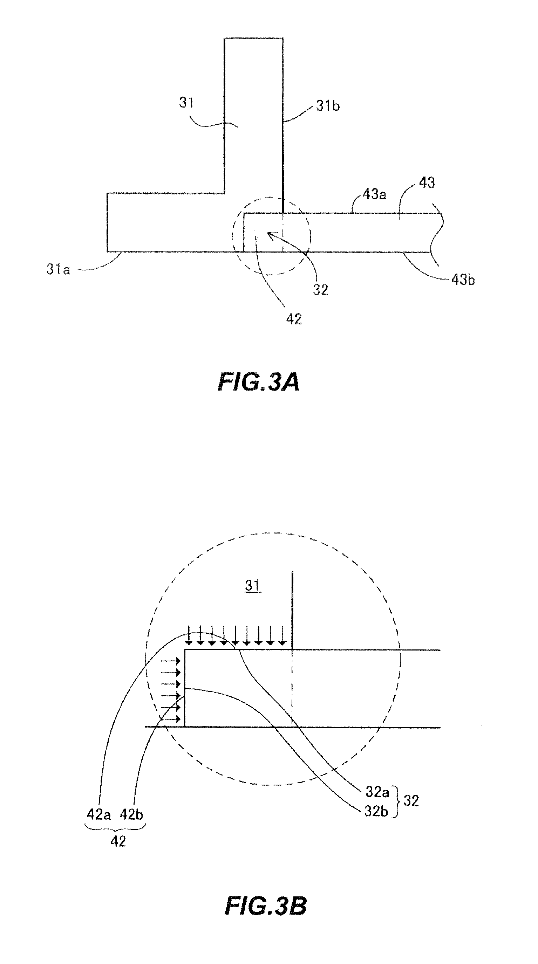

FIG. 3A is a partially enlarged cross-sectional view illustrating the power module 10, and FIG. 3B is a partially enlarged cross-sectional view illustrating a portion circled by a dotted line in FIG. 3A. In the casing 31, a circumferential edge 42 of the chip mounting electrode 41 is fitted into a notch 32 provided in a lower portion of the inner wall 31b, and an upper portion of the inner wall 31b surrounds the whole circumference of the chip mounting electrode 41. The notch 32 as a fitting portion (coupling portion) is a space formed by the horizontal wall 32a and a vertical wall 32b.

Here, assuming that the casing 31 has a box shape in which the entire cap and a part of the bottom are cut away, notches 32 are provided in the lower portions of four inner walls 31b having a flat wall shape of the casing 31.

Meanwhile, a planar face shape of the chip mounting electrode 41 having a flat plate shape is rectangular. In order to allow the circumferential edge 42 of the chip mounting electrode 41 to be inserted and fitted into the notch 32, the chip mounting electrode 41 extends in a surface direction (horizontal direction in FIG. 3A). Hereinafter, the chip mounting electrode corresponding to a portion fitted to the notch is defined as a "circumferential edge portion," and the remaining portion other than the circumferential edge portion is defined as an "electrode body portion." In this manner, by dividingly define the chip mounting electrode 41 into two portions, the chip mounting electrode 41 includes a circumferential edge portion 42 and an electrode body portion 43 as illustrated in FIG. 3A. In addition, a one-dotted chain line is delineated in a boundary between the circumferential edge portion 42 and the electrode body portion 43. The one-dotted chain line will be similarly delineated in the embodiments described below.

By inserting and fitting the circumferential edge portion 42 into the notch 32, the upper face 42a of the circumferential edge portion 42 and the horizontal wall 32a of the notch 32 abut on each other and are sealed, and the side face 42b of the circumferential edge portion 42 and the vertical wall 32b of the notch 32 abut on each other and are sealed, so as to prevent the sealing material 65 from leaking from the abutting surface between the notch 32 of the casing 31 and the circumferential edge portion 42 of the chip mounting electrode 41.

However, a manufacturing variation is inevitably generated in the casing 31 or the chip mounting electrode 41. Therefore, if there is a gap in the abutting surface between the notch 32 of the casing 31 and the circumferential edge portion 42 of the chip mounting electrode 41, it is difficult to perfectly prevent leakage of the sealing material 65. In addition, if there is a narrow portion in the structure, it is difficult to cure the gel in the narrow portion in comparison with the gel in other normal portions. Therefore, there is a possibility that uncured remnants may leak after a gel sealing/curing process.

In this regard, according to the first embodiment of the present invention, materials of the casing 31 and the chip mounting electrode 41 are selected to allow a contraction rate of the material of the casing 31 to be higher than that of the material of the chip mounting electrode 41 (electric conduction portion), and the casing 31 and the chip mounting electrode 41 are integrally molded.

The material of the casing 31 may include, for example, a resin material such as polyphenylene sulfide (PPS), polybutylene terephthalate (PBT), liquid crystal polymer (LCP), aromatic polyamide (PA6T), or polyamide 66 (PA66). Meanwhile, the material of the chip mounting electrode 41 may include, for example, a metal material such as copper (Cu), copper-molybdenum alloy (CuMo), copper-tungsten alloy (CuW), molybdenum-tungsten alloy (MoW), and aluminum (Al) or a ceramic-metal composite material such as aluminum·silicon carbide (AlSiC).

As a method of integrally molding the casing 31 and the chip mounting electrode 41, for example, there is known a method of running a melted resin material into a mold where the chip mounting electrode 41 is set (arranged) to mold the casing 31 and extracting the molded casing from the mold after the resin material is hardened. This integral molding method is used throughout overall embodiments.

When the casing 31 and the chip mounting electrode 41 are integrally molded, the casing 31 contracts more significantly than the chip mounting electrode 41 because the casing 31 is made of a resin material having a contraction rate higher than that of the material of the chip mounting electrode 41. By virtue of this difference of the contraction rate, a constant pressure is applied in a direction perpendicular to the surface of the circumferential edge from the surrounding to the entire outer circumference of the circumferential edge portion 42 abutting on the casing 31. Here, the outer circumference of the circumferential edge portion 42 abutting on the casing 31 includes an upper face 42 which is a horizontal plane and a side face 42b which is a vertical plane. Therefore, a pressure on the upper face 42a of the circumferential edge portion 42 is applied vertically downwardly from the horizontal wall 32a of the notch 32, and a pressure on the side face 42b of the circumferential edge portion 42 is applied from the vertical wall 32b of the notch 32 to the inner side of the casing (right side of FIG. 3B) (refer to the arrows in FIG. 3B). That is, by virtue of contraction of the casing 31 and the chip mounting electrode 41 generated at the time of integral molding, the casing 31 around the notch presses the circumferential edge portion 42 in both the horizontal and vertical directions.

As a result, adherence between the casing 31 and the chip mounting electrode 41 is improved on both the vertical abutting surface (in a thickness direction (vertical direction in FIG. 3B) of the chip mounting electrode 41) and the horizontal abutting surface (in a surface direction (horizontal direction in FIG. 3B) of the chip mounting electrode 41). That is, since a gap is removed from both the abutting surfaces between the casing 31 and the chip mounting electrode 41, it is possible to prevent the sealing material 65 from leaking out of the casing 31 through the gap of the abutting surface between the casing 31 and the chip mounting electrode 41.

Here, effects and advantages of the first embodiment will be described as follows. Specifically, the semiconductor device according to the first embodiment includes: the chip mounting electrode 41 (electric conduction portion) having a flat plate shape, the semiconductor chip 51 (semiconductor element) being arranged vertically over the chip mounting electrode and electrically connected thereto; the casing 31 whose lower portion of the inner wall 31b has a notch 32 (fitting portion) where the circumferential edge portion 42 of the chip mounting electrode 41 is fitted and whose upper portion of the inner wall 31b surrounds the whole circumference of the chip mounting electrode 41; and a sealing material 65 that vertically downwardly encapsulates the semiconductor chip 51 and the chip mounting electrode 41. In this semiconductor device, a contraction rate of the material of the casing 31 is higher than that of the material of the chip mounting electrode 41, and the chip mounting electrode 41 and the casing 31 are integrally molded. In this manner, according to the first embodiment, a part of the casing 31 1 around the notch 32 provided in the lower portion of the inner wall 31b of the casing 31 contracts more significantly than the circumferential edge portion 42 fitted to this notch 32 when the casing 31 and the chip mounting electrode 41 are integrally molded. By virtue of such a difference of the contraction rate between the casing 31 and the chip mounting electrode 41 at the time of the integral molding, the casing 31 around the notch 32 abuts on the circumferential edge portion 42 of the chip mounting electrode 41 across both the vertical abutting surface (thickness direction of the chip mounting electrode 41) and the horizontal abutting surface (surface direction of the chip mounting electrode 41) even when there is a manufacturing variation in sizes of the casing 31 and the chip mounting electrode 41. Therefore, a gap in the abutting surface between the circumferential edge portion 42 of the chip mounting electrode 41 and the casing 31 is removed, and it is possible to prevent the sealing material 65 from leaking out of the casing.

### <Second Embodiment>

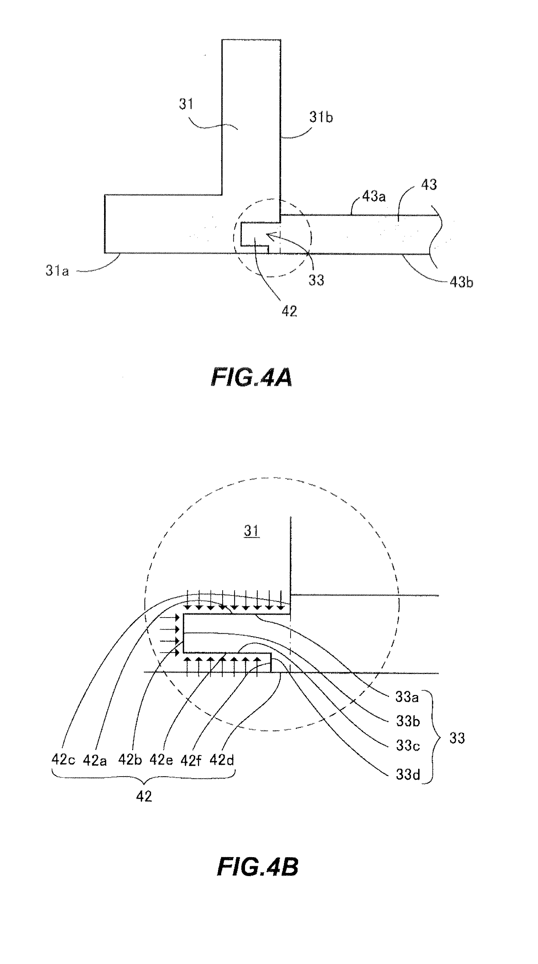

FIG. 4A is a partially enlarged cross-sectional view illustrating a power module 10 according to the second embodiment, and FIG. 4B is a partially enlarged cross-sectional view illustrating a portion circled by a dotted line in FIG. 4A, where like reference numerals denote like elements as in FIGS. 3A and 3B of the first embodiment.

In the first embodiment, the thickness (vertical thickness) of the circumferential edge portion 42 of the chip mounting electrode 41 is equal to that of the electrode body portion 43 of the chip mounting electrode 41. According to the second embodiment, the thickness of the circumferential edge portion 42 is smaller than that of the electrode body portion 43, and a trench 33 having a shape fitted to the circumferential edge portion 42 is provided in the lower portion of the inner wall 31b of the casing 31 as a fitting portion. That is, as illustrated in FIG. 4B, the circumferential edge portion 42 includes a single upper face 42a, two lower faces 42d and 42e, and three side faces 42b, 42c, and 42f. Since the number of lower faces is set to 2, the lower faces 42d and 42e are referred to as first and second lower faces, respectively. Since the number of side faces is set to 3, the side faces 42b, 42c, and 42f are referred to as first, second, and third side faces, respectively.

The upper face 42a of the circumferential edge portion 42 is positioned lower than the upper face 43a of the electrode body portion 43. The upper face 42a of the circumferential edge portion 42 and the upper face 43a of the electrode body portion 43 are linked to each other with the second side face 42c. The first lower face 42d is coplanar with the lower face 43b of the electrode body portion 43, and the second lower face 42e is positioned higher than the first lower face 42d. The first and second lower faces 42d and 42e are linked to each other with the third side face 42f. In order to reduce the thickness of the circumferential edge portion 42 to be smaller than that of the electrode body portion 43 in this manner, for example, methods such as pressing or cutting may be used.

Meanwhile, the trench 33 (fitting portion) includes two horizontal walls 33a and 33c and two vertical walls 33b and 33d as illustrated in FIG. 4B. Since the number of horizontal walls is set to 2, the horizontal walls 33a and 33c are referred to as first and second horizontal walls, respectively. Similarly, since the number of vertical walls is set to 2, the vertical walls 33b and 33d are referred to as first and second vertical walls, respectively.

The first horizontal wall 33a is positioned lower than the upper face 43a of the electrode body portion 43, and the second horizontal wall 33c is positioned higher than the lower face 31a of the casing 31. The second side wall 33d is positioned in an outer side of the casing (left side in FIG. 4B) relative to the casing inner wall 31b.

According to the second embodiment, since the lower portion of the inner wall 31b of the casing 31 is provided with not a notch but a trench 33 as a fitting portion, the casing 30 also abuts on the second lower face 42e of the circumferential edge portion 42. For this reason, when the casing 31 and the chip mounting electrode 41 are integrally molded, a pressure is applied vertically downwardly on the upper face 42a of the circumferential edge portion 42 from the first horizontal wall 33a of the trench 33, and a pressure is applied vertically upwardly on the second lower face 42e of the circumferential edge portion 42 from the second horizontal wall 33c of the trench 33 (refer to the arrows in FIG. 4B). That is, the pressure is generated to interpose the circumferential edge portion 42 vertically upwardly and vertically downwardly by virtue of contraction generated at the time of integral molding. Therefore, adherence of the two horizontal abutting surfaces between the casing 31 and the chip mounting electrode 41 is further improved.

Since the casing 31 is provided with the trench 33, a contact surface in a portion where the chip mounting electrode 41 and the casing 31 are coupled is widened, so as to lengthen a distance through which the sealing material 65 passes until the sealing material 65 leaks out of the casing. Therefore, it is possible to suppress leakage of the sealing material 65.

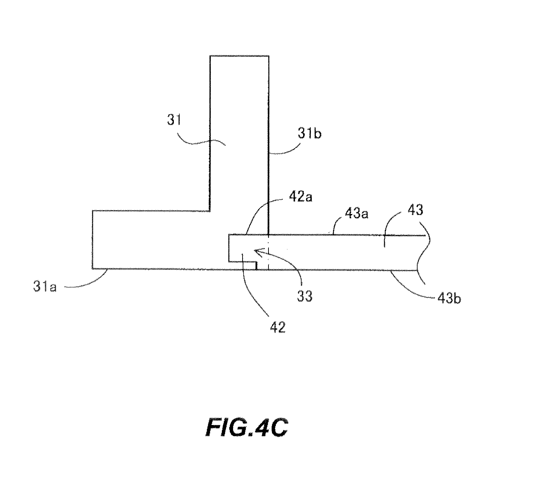

FIG. 4C is a diagram illustrating a modified configuration in which the upper face 42a of the circumferential edge portion 42 is coplanar with the upper face 43a of the electrode body portion 43. Similarly, in the configuration of FIG. 4C, the thickness of the circumferential edge portion 42 is smaller than that of the electrode body portion 43, and a trench 33 having a shape fitted to the circumferential edge portion 42 is provided in the lower portion of the inner wall 31b of the casing 31 as a fitting portion. Therefore, it is possible to obtain and effects similar to those of the configuration of FIG. 4A.

As described above, according to the second embodiment, the thickness of the circumferential edge portion 42 is smaller than that of the electrode body portion 43, and the trench 33 having a shape fitted to the circumferential edge portion 42 is provided in the lower portion of the inner wall 31b of the casing 31 as a fitting portion. Therefore, the casing 31 around the trench 33 abuts on the circumferential edge portion 42 of the chip mounting electrode 41 vertically upwardly and vertically downwardly as well as horizontally. As a result, it is possible to further reduce the gap in the abutting surface between the circumferential edge portion 42 of the chip mounting electrode 41 and the casing 31.

### <Third Embodiment>

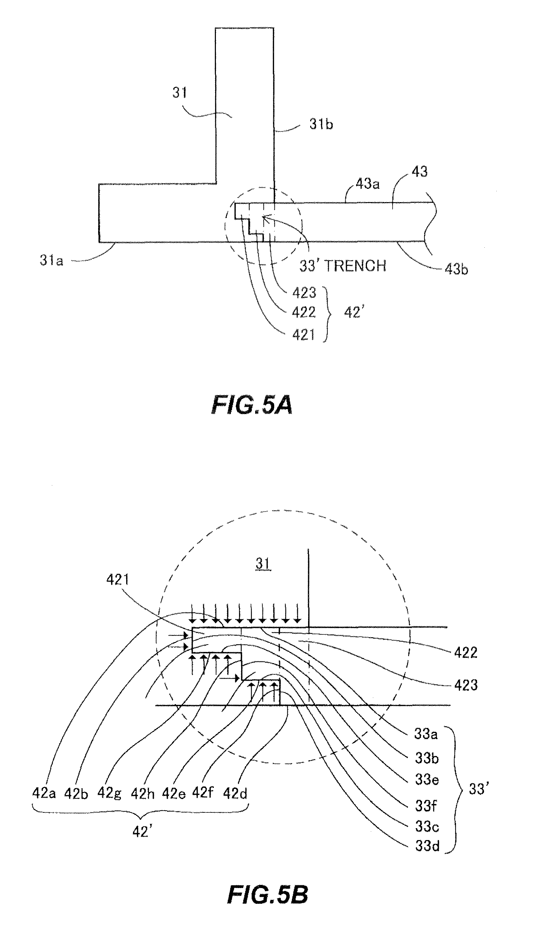

FIG. 5A is a partially enlarged cross-sectional view illustrating a power module 10 according to the third embodiment, and FIG. 5B is a partially enlarged cross-sectional view illustrating a portion circled by a dotted line in FIG. 5A, where like reference numerals denote like elements as in FIGS. 3A and 3B of the first embodiment.

Similar to the second embodiment, by reducing the thickness of the circumferential edge portion 42 to be smaller than that of the electrode body portion 43, a pressure is generated to interpose the circumferential edge portion 42 vertically upwardly and vertically downwardly by virtue of contraction generated when the casing 31 and the chip mounting electrode 41 are integrally molded, so as to increase adherence of the horizontal abutting surface between the casing 31 and the chip mounting electrode 41. However, in this configuration, as the thickness of the circumferential edge portion 42 is reduced, a strength of the circumferential edge portion 42 against bending or deformation decreases accordingly.

According to the third embodiment, in order to address such a problem, the circumferential edge portion 42' has a step-down shape whose thickness is reduced toward the outer circumference of the chip mounting electrode 41, and a trench 33' having a shape fitted to the circumferential edge portion 42' is provided in the lower portion of the inner wall 31b of the casing 31 as a fitting portion. That is, the circumferential edge portion 42' includes a single upper face 42a, three lower faces 42d, 42e, and 42g, and three side faces 42b, 42f, and 42h as illustrated in FIG. 5B. Since the number of lower faces is set to 3, the lower faces 42d, 42e, and 42g are referred to as first, second, and third lower faces, respectively. Since the number of side faces is set to 3, the side faces 42b, 42f, and 42h are referred to as first, second, and third side faces, respectively.

The first lower face 42d is coplanar with the lower face 43b of the electrode body portion 43, the second lower face 42e is positioned higher than the first lower face 42d, and the third lower face 42g is positioned higher than the second lower face 42e. The first and second lower faces 42d and 42e are linked to each other with the second side face 42f, and the third lower face 42g and the second lower face 42e are linked to each other with the third side face 42h. In this manner, in order to make the circumferential edge portion 42' to have a step-down shape whose thickness is reduced toward the outer circumference of the chip mounting electrode 41, for example, methods such as pressing or cutting may be used.

Meanwhile, the trench 33' (fitting portion) includes three horizontal walls 33a, 33c, and 33e and three vertical walls 33b, 33d, and 33f as illustrated in FIG. 5B. Since the number of horizontal walls is set to 3, the horizontal walls 33a, 33c, and 33e are referred to as first, second, and third horizontal walls, respectively. Since the number of vertical walls is set to 3, the vertical walls 33b, 33d, and 33f are referred to as first, second, and third vertical walls, respectively.

The first horizontal wall 33a is coplanar with the upper face 43a of the electrode body portion 43, the second horizontal wall 33c is positioned higher than the lower face 31a of the casing 31, and the third horizontal wall 33e is positioned higher than the second horizontal wall 33c and lower than the first horizontal wall 33a. The second vertical wall 33d is positioned in the casing inner wall 31b side (right side in FIG. 5B) relative to the first vertical wall 33b, and the third vertical wall 33f is positioned between the first vertical wall 33b and the second vertical wall 33d.

Now, consideration will be made only for a vertical pressure by dividing the circumferential edge portion 42' into three portions including first, second, and third circumferential edge portions 421, 422, and 423 from the outer circumference side as illustrated in FIG. 5A (refer to the one-dotted chain line). When the casing 31 and the chip mounting electrode 41 are integrally molded, a vertical downward pressure is applied only to the upper face 42a in the third circumferential edge portion 423. In the second circumferential edge portion 422, a vertical downward pressure is applied to the upper face 42a, and a vertical upward pressure is applied to the lower face 42e. In the first circumferential edge portion 421, a vertical downward pressure is applied to the upper face 42a, and a vertical upward pressure is applied to the lower face 42g (refer to the arrows in FIG. 5B). Here, since the thickness decreases in the order of third, second, and first circumferential edge portions 423, 422, and 421, the force applied in a thickness direction increases in the order of third, second, and first circumferential edge portions 423, 422, and 421. That is, horizontal adherence of the abutting surface between the casing 31 and the chip mounting electrode 41 is improved in the order of third, second, and first circumferential edge portions 423, 422, and 421. Meanwhile, since the thickness increases in the order of first, second, and third circumferential edge portions 421, 422, and 423, the strength of the circumferential edge portion is improved in this order.

In this manner, according to the third embodiment, the circumferential edge portion 42' has a step-down shape whose thickness is reduced toward the outer circumference of the chip mounting electrode 41, and the trench 33' having a shape fitted to the circumferential edge portion 42' is provided in the lower portion of the inner wall 31b of the casing 31 as a fitting portion. As a result, as the thickness of the circumferential edge portion 42' decreases toward the outer circumference of the chip mounting electrode 41 (left side in FIG. 5B), horizontal adherence of the abutting surface between the casing 31 and the chip mounting electrode 41 is improved accordingly. In addition, as the thickness of the circumferential edge portion 42' increases toward the center of the chip mounting electrode 41 (right side in FIG. 5B), the strength of the circumferential edge portion 42' is improved accordingly. According to the third embodiment, it is possible to obtain both the adherence with the casing 31 and the strength of the chip mounting electrode 41.

In the third embodiment, while description has been made for a case where the circumferential edge portion has a step-down shape whose thickness is reduced toward the outer circumference of the chip mounting electrode 41, and the trench having a shape fitted to the circumferential edge portion is provided in the lower portion of the inner wall 31b of the casing 31 as a fitting portion, the invention is not limited thereto. For example, the circumferential edge portion may have a tapered shape whose thickness is reduced toward the outer circumference of the chip mounting electrode 41, and a trench having a shape fitted to the circumferential edge portion may be provided in the lower portion of the inner wall 31b of the casing 31 as a fitting portion.

### <Fourth Embodiment>

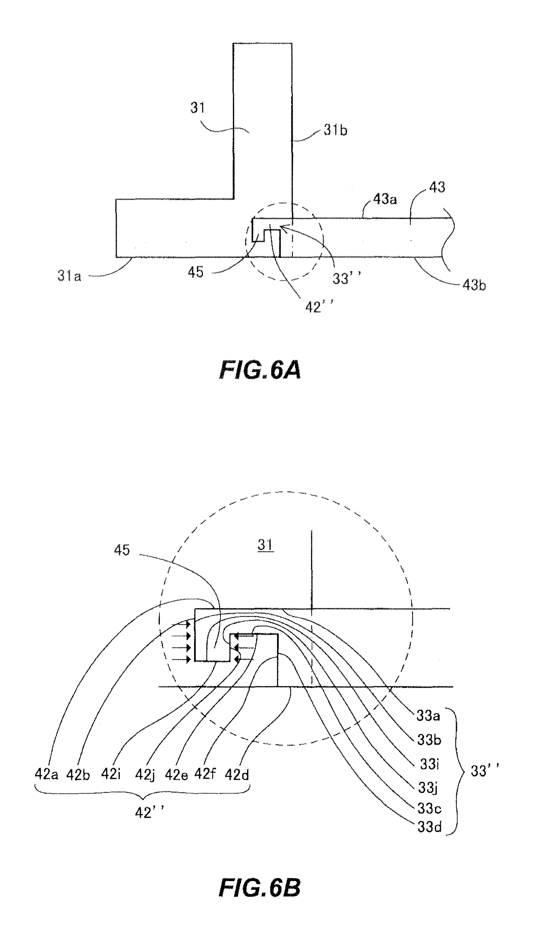

FIG. 6A is a partially enlarged cross-sectional view illustrating a power module 10 according to the fourth embodiment, and FIG. 6B is a partially enlarged cross-sectional view illustrating a portion circled by a dotted line in FIG. 6A, where like reference numerals denote like elements as in FIGS. 3A and 3B of the first embodiment.

In a case where the casing 31 and the chip mounting electrode 41 are warmed to a high temperature due to an ambient temperature change after the casing 31 and the chip mounting electrode 41 are integrally molded, a phenomenon inverse to that generated in the integral molding occurs. That is, the casing 31 which is made of a resin material having a contraction rate higher than that of the chip mounting electrode 41 significantly expands due to the high temperature. As a result, the pressure applied to the outer circumference of the circumferential edge portion 42 which abuts on the casing 31 may be removed, and a gap may be generated in the abutting surface between the casing 31 and the chip mounting electrode 41.

According to the fourth embodiment, in order to address such a problem, an outermost side of a circumferential edge portion" is shaped to have a protrusion 45 protruding vertically downwardly in the vertical direction from the inner side thereof, and a trench 33" having a shape fitted to the circumferential edge portion" is provided in the lower portion of the inner wall 31b of the casing 31 as a fitting portion. That is, the circumferential edge portion 42" includes a single upper face 42a, three lower faces 42d, 42e, and 42i, and three side faces 42b, 42f, and 42j as illustrated in FIG. 6B. Since the number of lower faces is set to 3, the lower faces 42d, 42e, and 42i are referred to as first, second, and fourth lower faces, respectively. Since the number of side faces is set to 3, the side faces 42b, 42f, and 42j are referred to as first, second, and fourth side faces, respectively.

The first lower face 42d is coplanar with the lower face 43b of the electrode body portion 43, the second lower face 42e is positioned higher than the first lower face 42d, and the fourth lower face 42i is positioned between the second lower face 42e and the first lower face 42d. The first and second lower faces 42d and 42e are linked to each other with the third side face 42f, and the fourth and second lower faces 42i and 42e are linked to each other with the fourth side face 42j. In this manner, in order to shape the outermost side of the circumferential edge portion 42" to have a protrusion 45 protruding vertically downwardly from the inner side thereof, for example, methods such as a pressing or cutting may be used.

Meanwhile, as illustrated in FIG. 6B, the trench 33" (fitting portion) includes three horizontal walls 33a, 33c, and 33i and three vertical walls 33b, 33d, and 33j. Since the number of horizontal walls is set to 3, the horizontal walls 33a, 33c, and 33i are referred to as first, second, and fourth horizontal walls, respectively. Since the number of vertical walls is set to 3, the vertical walls 33b, 33d, and 33j are referred to as first, second, and fourth vertical walls, respectively.

The first horizontal wall 33a is coplanar with the upper face 43a of the electrode body portion 43, the second horizontal wall 33c is positioned higher than the lower face 31a of the casing 31, and the fourth horizontal wall 33i is positioned between the first and second horizontal walls 33a and 33c. The second vertical wall 33d is positioned in the inner wall side of the casing (right side in FIG. 6B) relative to the first vertical wall 33b, and the fourth vertical wall 33j is positioned between the first and second vertical walls 33b and 33d.

In a case where the casing 31 and the chip mounting electrode 41 are warmed to a high temperature due to an ambient temperature change, and the casing 31 and the chip mounting electrode 41 expand, a pressure in the first side face 42b which is one of the side faces of the protrusion 45 is applied from the first vertical wall 33b to the casing inner wall 31 b side (right side in FIG. 6B), and a pressure in the fourth side face 42j which is the other side face of the protrusion 45 is applied from the fourth vertical wall 33j to the outer side of the casing (left side in FIG. 6B) (refer to the arrows in FIG. 6B). That is, since the pressure is generated to interpose the protrusion 45 from both sides in the horizontal direction by virtue of expansion of the casing 31 and the chip mounting electrode 41, adherence of the abutting surface in the vertical direction between the casing 31 and the chip mounting electrode 41 is further improved.

In this manner, according to the fourth embodiment, the outermost side of the circumferential edge portion 42" is shaped to have a protrusion 45 protruding vertically from the inner side thereof, and the trench 33" having a shape fitted to the circumferential edge portion 42" is provided in the lower portion of the inner wall 31b of the casing 31 as a fitting portion. As a result, in a case where the casing and the electric conduction portion are warmed to a high temperature due to an ambient temperature change and expand, the casing 31 around the protrusion 45 abuts on the circumferential edge portion 42" of the chip mounting electrode 41 from both horizontal sides. Therefore, it is possible to reduce a gap in the abutting surface between the casing 31 and the chip mounting electrode 41 and prevent the sealing material 65 from leaking out of the casing even when expansion occurs due to an ambient temperature change.

While the present invention has been described in detail with reference to the accompanying drawings hereinbefore, it is not intended to limit the invention to such specific configurations. Various modifications, changes, and the like may be possible without departing from the spirit and scope of the invention and equivalents thereof as disclosed in claims.

This application claims priority based on JP2010-227823, filed with the Japan Patent Office on October 7, 2010, the entire contents of which are incorporated into this specification by reference.

## Claims

1. A semiconductor device comprising:
an electric conduction portion (41) having a flat plate shape, a semiconductor element being arranged vertically over the electric conduction portion and being electrically connected thereto;
a casing (31) whose lower portion of an inner wall has a coupling portion coupled with a circumferential edge portion of the electric conduction portion (41) and whose upper portion of the inner wall surrounds the whole circumference of the electric conduction portion (41); and
a sealing material (62) that vertically downwardly encapsulates the semiconductor element and the electric conduction portion (41),
wherein the electric conduction portion (41) and the casing are integrally molded, and a space having a shape coupled to a circumferential edge portion of the electric conduction portion (41) is provided in the lower portion of the inner wall of the casing as the coupling portion.

2. The semiconductor device according to claim 1, wherein a thickness of the circumferential edge portion of the electric conduction portion (41) is smaller than that of the remaining electric conduction portion other than the circumferential edge portion, and
a trench having a shape coupled to the circumferential edge portion of the electric conduction portion (41) is provided in a lower portion of the inner wall of the casing as the coupling portion.

3. The semiconductor device according to claim 1 or 2, wherein a contraction rate of a material of the casing (31) is higher than that of a material of the electric conduction portion (41).

4. The semiconductor device according to claim 1, wherein the circumferential edge portion has a step-down or tapered shape whose thickness is reduced toward an outer circumference of the electric conduction portion (4 1), and
a trench having a shape coupled to the circumferential edge portion of the electric conduction portion (41) is provided in a lower portion of the inner wall of the casing as a coupling portion.

5. The semiconductor device according to claim 1, wherein the circumferential edge portion is shaped in an outermost side to have a protrusion protruding vertically from an inner side thereof, and
a trench having a shape coupled with the circumferential edge portion of the electric conduction portion (41) is provided in a lower portion of the inner wall of the casing as the coupling portion.

6. A method of manufacturing a semiconductor device comprising:
arranging a semiconductor element vertically over an electric conduction portion (41) having a flat plate shape and making electric connection;
providing a coupling portion in a lower portion of an inner wall of a casing (31) whose upper portion of an inner wall surrounds the whole circumference of the electric conduction portion (41) and coupling the coupling portion with a circumferential edge portion of the electric conduction portion (41); and
vertically downwardly encapsulating the semiconductor element and the electric conduction portion (4 1) with a sealing material (62),
wherein the electric conduction portion (41) and the casing (31) are integrally molded by running the resin material into a mold where the electric conduction portion (41) is set.
